# DEMANDE DE BREVET EUROPEEN

(11) **EP 4 492 442 A2**
(43) Date de publication de la demande: **15.01.2025**
(21) Numéro de dépôt: 24187498.1
(22) Date de dépôt: 09.07.2024
(51) Int. Cl.: H01L 21/677, H01L 21/687

(54) **DISPOSITIF DE PRÉHENSION DE PLAQUETTES**

(30) Priorité: 11.07.2023 FR 2307400
(71) Demandeur: Commissariat à l'Energie Atomique et aux Energies Alternatives, 75015 Paris (FR)
(72) Inventeur: JERONIMO, Pedro, 38054 GRENOBLE CEDEX 09 (FR)
(74) Mandataire: Brevalex

(57) **Abrégé**

L'invention concerne un dispositif de préhension d'au moins une plaquette de matériau semi-conducteur. Le dispositif comprend au moins une unité de préhension (120) comprenant une paire d'organes de préhension (140, 150) disposés à distance l'un de l'autre et comportant chacun une encoche, l'encoche d'un des organes de préhension (140, 150) étant adaptée pour recevoir un bord de ladite au moins une plaquette tandis que l'encoche de l'autre des organes de préhension (150, 140) étant adaptée pour recevoir un bord opposé de ladite au moins une plaquette, et un moyen de déplacement (160) configuré pour rapprocher/écarter les organes de préhension (140, 150) l'un de l'autre entre une configuration de verrouillage de l'au moins une plaquette en vue de sa préhension et une configuration d'insertion.

## Description

### DOMAINE TECHNIQUE

L'invention est relative au domaine du transport, de la préhension/manipulation, ou de l'acheminement de substrats, ou plaquettes, de matériau semi-conducteur lors de la réalisation de dispositifs à partir de ces substrats.

L'invention s'applique avantageusement à des substrats semi-conducteurs destinés à la réalisation de cellules photovoltaïques, mais également à des substrats semi-conducteurs destinés à la réalisation de dispositifs microélectroniques.

### ETAT DE LA TECHNIQUE

Au cours de la réalisation de dispositifs semi-conducteurs (par exemple photovoltaïques, microélectroniques, etc.), les plaquettes, à partir desquelles ces dispositifs sont réalisés, passent successivement dans différents équipements au sein desquels elles sont soumises à différents traitements permettant de réaliser les dispositifs semi-conducteurs : dépôt de matériaux, gravure, photolithographie, etc.

Lors de ces différents traitements, les plaquettes sont classiquement maintenues en position dans les différents équipements par des dispositifs de maintien adaptés, communément dénommés « paniers ». Ces dispositifs permettent notamment d'éviter l'endommagement des plaquettes, de garantir une application efficace des traitements ou encore les maintenir immergées lors de traitements chimiques notamment, en contrant par exemple des phénomènes tels que la poussée d'Archimède.

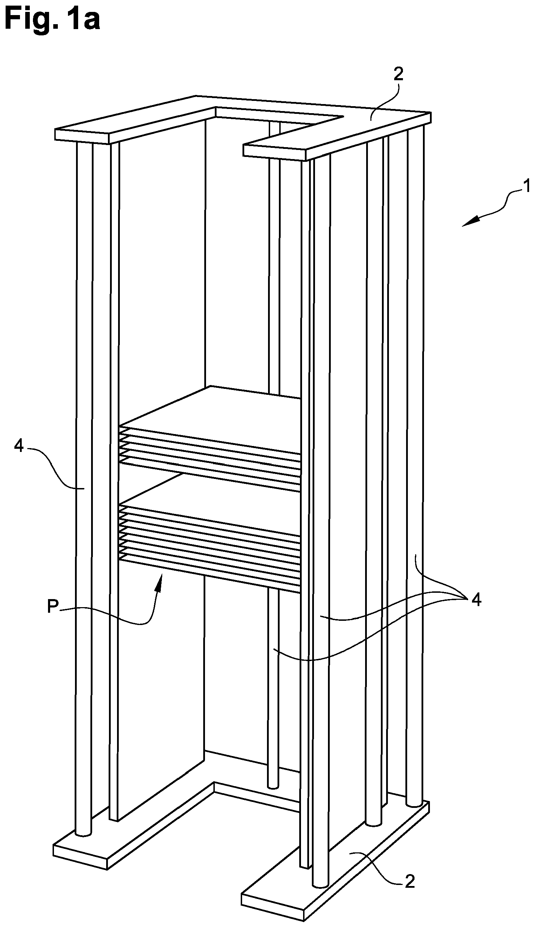

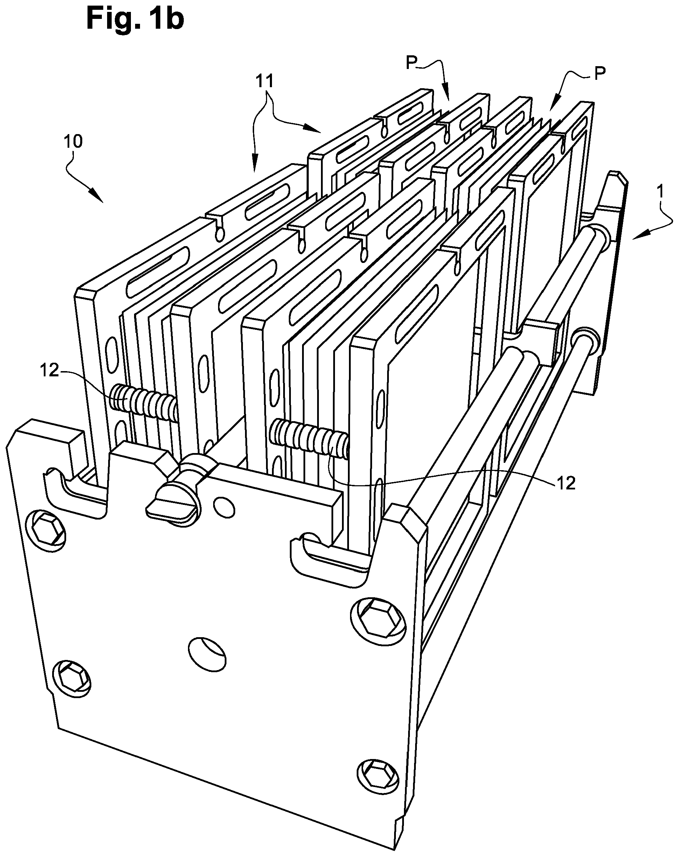

Des dispositifs de maintien connus sont représentés sur la figure 1a et la figure 1b des dessins annexés, en particulier :
- la figure 1a est une vue en perspective d'un dispositif de maintien ou panier connu, orienté verticalement et dans lequel sont insérées des plaquettes ; et
- la figure 1b est une vue en perspective d'un dispositif d'immersion connu, orienté horizontalement et comprenant un dispositif similaire à celui de la figure 1a ainsi que des inserts, insérés dans le dispositif de la figure 1a et logeant chacun une pluralité de plaquettes.

Ces dispositifs permettent de maintenir des plaquettes P parallèlement et à distance les unes des autres. Ils ont classiquement des dimensions adaptées à la taille des plaquettes à recevoir. Une taille standard de plaquette peut par exemple aller d'un carré ou d'un quasi-carré de 156,75 mm de côté, dite taille M2, à un carré ou d'un quasi-carré de 210 mm de côté, dite taille M12. Par quasi-carré, on entend un carré dont les coins peuvent être coupés.

Le dispositif 1 illustré à la figure 1a comporte deux flasques d'extrémité 2 portant des barres de maintien 4 des plaquettes P. Les flasques d'extrémité 2 ont une forme de U permettant le chargement/déchargement des plaquettes P par le haut (c'est-à-dire la partie ouverture du U) lorsque le dispositif 1 est disposé horizontalement. Les barres de maintien 4 sont pourvues de dents de séparation qui maintiennent les plaquettes P à distance, parallèlement les unes aux autres. L'écartement entre deux plaquettes P consécutives est typiquement égal à 4,76 mm pour des plaquettes de taille M2 ou 6,3 mm pour des plaquettes de taille M12.

Le dispositif 10 illustré à la figure 1b est formé par un dispositif de maintien 1, similaire à celui de la figure 1a, et des inserts 11 insérés de manière amovible dans le dispositif 1. Les inserts 11 permettent au dispositif de maintien 1 d'accueillir des plaquettes P d'une taille différente de celle prévue pour le dispositif d'immersion 1 lui-même. Chaque insert 11 comporte ainsi des barres de maintien 12 dentelées qui maintiennent les plaquettes P de la même manière que le dispositif de la figure 1a.

Pour décharger les plaquettes P, le dispositif de maintien 1 est généralement orienté à la verticale (comme illustré à la figure 1a) et positionné au-dessus d'un élément de manutention, telle qu'une courroie. De cette manière, les plaquettes P sont orientées parallèlement à une direction de déplacement de l'élément de manutention. Le dispositif de maintien est ensuite abaissé progressivement de sorte que les plaquettes P sont déchargées unes à unes, par friction avec l'élément de manutention. Ce processus peut être similaire pour chaque insert 11 illustré à la figure 1b.

Au cours de ce processus de déchargement, les zones de la plaquette P entrant en contact avec l'élément de manutention sont détériorées. Les défauts résultant de ces dégradations de surface sont englobés sous le terme « défectivité ». Les éléments réalisés ultérieurement sur ces zones (où la surface de la plaquette est dégradée) sont de moindre qualité.

Des solutions ont été développées pour limiter la défectivité lors du processus de déchargement des plaquettes. Par exemple, la demande de brevet français FR 2 213 736, déposée par le demandeur, propose une solution comportant un élément de manutention, telle qu'une courroie, ayant une surface sur laquelle sont ménagés des éléments de support en saillie. Ces éléments de supports sont destinés à venir au contact d'une zone de la plaquette de sorte à maintenir le reste de la plaquette à distance de la surface de l'élément de manutention. La surface de contact entre la plaquette et l'élément de manutention est ainsi réduite.

En réduisant la surface de contact entre la plaquette et l'élément de manutention, la défectivité est effectivement réduite. Cependant, cette solution requiert un contact au niveau d'une face des plaquettes, et plus particulièrement à distance des bords (quelques millimètres) afin de garantir une stabilité suffisante lors du transport. Cela impose de ménager des zones sensibles à l'écart des zones de contact au risque de les endommager. La surface exploitable de la face des plaquettes n'est alors pas maximisée par rapport à la surface disponible.

De plus, la cadence de déchargement avec les processus actuels est limitée à une plaquette à la fois et est conditionnée par la vitesse de déplacement de l'élément de manutention, notamment la courroie, qui est adaptée pour limiter, voire éviter, le glissement de l'élément de support sur la face de la plaquette, ce qui peut entraîner un ralentissement de la production de dispositifs semi-conducteurs et des coûts supplémentaires.

### EXPOSE DE L'INVENTION

Afin de résoudre les inconvénients précités, l'invention propose, selon un premier aspect, un dispositif de préhension d'au moins une plaquette de matériau semi-conducteur. Le dispositif de préhension comprend au moins une unité de préhension comprenant une paire d'organes de préhension disposés à distance l'un de l'autre et comportant chacun une encoche, l'encoche d'un des organes de préhension étant adaptée pour recevoir un bord de ladite au moins une plaquette tandis que l'encoche de l'autre des organes de préhension étant adaptée pour recevoir un bord opposé de ladite au moins une plaquette, et un moyen de déplacement configuré pour rapprocher/écarter les organes de préhension l'un de l'autre entre une configuration de verrouillage de l'au moins une plaquette en vue de sa préhension et une configuration d'insertion, caractérisé en ce qu'il comprend plusieurs unités de préhension espacées les unes des autres selon une direction perpendiculaire à un plan défini par les organes de préhension d'une des unités de préhension.

Il est entendu par « plaquette de matériau semi-conducteur » ou « plaquette », autrement dénommée « wafer » en langue anglo-saxonne, un substrat ayant une forme de pavé droit de faible épaisseur, formé à partir d'un matériau semi-conducteur, généralement du silicium et/ou du germanium, et plus particulièrement du silicium cristallin. L'épaisseur de la plaquette peut être comprise entre 60 et 400 µm, par exemple de l'ordre de 140 µm. L'au moins une plaquette peut notamment être logée dans un dispositif de maintien.

Il est entendu par « unité de préhension », un ensemble adapté à la préhension d'une plaquette par le biais d'une paire d'organes de préhension agissant tels que des mors, lesquels peuvent être rapprochés/écartés l'un de l'autre par le biais d'un moyen de déplacement.

Il est entendu par « verrouillage » ou « configuration de verrouillage », le fait de rapprocher les organes de préhension d'une même paire l'un de l'autre de manière suffisante pour maintenir l'au moins une plaquette en position et notamment l'empêcher de se déplacer. Il convient de noter que le verrouillage n'implique pas nécessairement le serrage ou la compression de la plaquette entre les organes de préhension. Au contraire, il est préférable de limiter au maximum les efforts de compression lors du verrouillage, afin de ne pas endommager la plaquette.

Il est entendu par « insertion » ou « configuration d'insertion », le fait d'écarter les organes de préhension l'un de l'autre de manière suffisante pour pouvoir insérer ou retirer la plaquette du dispositif.

Grâce au dispositif de préhension, et notamment à la configuration de la paire d'organes de préhension, il est possible de saisir une plaquette de matériau semi-conducteur, qui est par exemple insérée dans un dispositif de maintien, par des bords opposés, et ainsi limiter, voire supprimer, le contact sur une face de cette plaquette. En saisissant la plaquette par ses bords opposés, il est possible de transporter la plaquette de façon suffisamment stable en évitant un contact avec l'une de ses faces, ce qui permet ainsi de tirer profit de l'intégralité de la surface disponible de la plaquette.

De plus, cela rend également possible de saisir une plaquette quelconque dans le dispositif de maintien, contrairement à la courroie avec laquelle les plaquettes doivent être déchargées consécutivement selon leur ordre d'empilement. Il est donc possible d'augmenter la cadence de déchargement des plaquettes, par exemple soit en utilisant le dispositif de préhension en combinaison avec un dispositif de manutention connu, soit en utilisant plusieurs dispositifs de préhension, soit en utilisant un dispositif de préhension adapté pour décharger plusieurs plaquettes à la fois.

Le dispositif peut ainsi saisir plusieurs plaquettes simultanément, ce qui permet notamment d'améliorer la cadence de déchargement des plaquettes insérées dans un dispositif d'immersion. L'espace séparant les unités de préhension est déterminé en fonction des dimensions des plaquettes, notamment leur épaisseur, et de leur agencement dans le dispositif de maintien.

Corrélativement, l'invention propose, selon un deuxième aspect, un procédé de préhension d'au moins une plaquette de matériau semi-conducteur, à l'aide d'un dispositif de préhension tel que décrit précédemment. Le procédé de préhension comprend les étapes suivantes :
- déplacer ledit dispositif de préhension, dans sa configuration d'insertion, jusqu'à ce que l'au moins une plaquette se trouve entre la paire d' organes de préhension de l'au moins une unité de préhension,
- actionner le moyen de déplacement pour faire passer le dispositif de sa configuration d'insertion à sa configuration de verrouillage pour la préhension de l'au moins une plaquette.

L'invention propose enfin, selon un troisième aspect, un ensemble de préhension comportant un dispositif de maintien, au moins une plaquette insérée dans le dispositif de maintien, un robot manipulateur, et un dispositif de préhension tel que décrit précédemment qui est monté sur le robot manipulateur, le robot manipulateur étant configuré pour déplacer le dispositif de préhension, dans sa configuration d'insertion, jusqu'à ce que l'au moins une plaquette se trouve entre la paire d'organes de préhension de l'au moins une unité de préhension, le moyen de déplacement étant configuré pour faire passer le dispositif de préhension de sa configuration d'insertion à sa configuration de verrouillage pour la préhension de ladite au moins une plaquette.

L'invention s'applique avantageusement pour des substrats destinés à la réalisation de dispositifs dans lesquels l'état de surface du substrat, c'est-à-dire la qualité du semi-conducteur, joue un rôle majeur sur la performance finale du dispositif. De plus, l'invention s'applique avantageusement pour des dispositifs dont la réalisation nécessite un transport rapide des substrats, avec une forte cadence, lors des étapes précédant la protection de la surface du substrat, c'est-à-dire les étapes précédant la passivation de surface du substrat à partir de laquelle le système de transport n'a plus ou presque plus d'impact sur la qualité du semi-conducteur du substrat.

L'invention s'applique avantageusement pour des substrats fins, c'est-à-dire dont l'épaisseur est inférieure ou égale à environ 100 µm, car ces substrats sont plus sensibles à la défectivité que des substrats épais de plusieurs centaines de microns. Ces substrats de silicium sont notamment destinés à la réalisation de cellules photovoltaïques.

Des caractéristiques préférées particulièrement simples, commodes et économiques du dispositif selon l'invention sont présentées ci-dessous.

Chaque encoche peut posséder un profil en forme de V. Cette géométrie permet de limiter encore, voire d'éviter le contact entre les organes de préhension et au moins une face de la plaquette. En cas de contact, la zone de de contact est alors située le long d'un bord ou sur une tranche de la plaquette, ce qui n'est pas particulièrement gênant.

Les organes de préhension peuvent être configurés pour coulisser l'un par rapport à l'autre selon une direction de rapprochement/d'écartement des organes de préhension sous l'action du moyen de déplacement. Ce mouvement de coulissement (ou selon une liaison glissière) permet au dispositif d'être compact, notamment selon une direction perpendiculaire à la direction de rapprochement/d'écartement des organes de préhension. De plus, la dimension du dispositif, selon cette direction, reste inchangée lors du passage d'une configuration à l'autre. Il est ainsi possible de positionner facilement le dispositif entre deux plaquettes, lesquelles sont généralement espacées d'une distance de 4,76 mm ou 6,3 mm selon leurs dimensions.

L'au moins une unité de préhension peut comporter un troisième organe de préhension, les organes de préhension étant disposés selon une configuration triangulaire, les encoches de deux de ces organes de préhension étant adaptées pour recevoir un même bord de l'au moins une plaquette, ou l'au moins une unité de préhension peut comporter une autre paire d'organes de préhension, les organes de préhension étant disposés selon une configuration globalement rectangulaire, chaque paire comportant un organe de préhension dont l'encoche est adaptée pour recevoir un bord de l'au moins une plaquette et un organe de préhension dont l'encoche est adaptée pour recevoir un bord opposé de ladite au moins une plaquette. La présence de deux paires d'organes de préhension ou bien de trois organes de préhension (un organe de préhension supérieur/inférieur et deux organe de préhension inférieurs/supérieurs) améliore la stabilité lors de la préhension de la plaquette. Cela limite donc de risque de chute et/ou de mobilité de la plaquette lors de sa préhension par le dispositif.

Au moins l'un des organes de préhension est associé à un moyen d'amortissement configuré pour se déformer élastiquement au-delà d'une contrainte prédéterminée s'exerçant lorsque les organes de préhension se rapprochent l'un de l'autre. Le moyen d'amortissement permet d'éviter d'endommager la plaquette en absorbant au moins partiellement le mouvement d'un des organes de préhension sur la plaquette lorsque le dispositif passe dans la configuration de verrouillage. En effet, dans le cas où les organes de préhension viennent au contact de la plaquette au cours de leur rapprochement, le moyen d'amortissement se déforme et limite l'effort sur la plaquette. Le moyen d'amortissement peut comporter un ressort de compression.

Le moyen de déplacement peut comprendre un axe numérique. Ce type d'actionneur permet de rapprocher et écarter les organes de préhension avec une vitesse de déplacement variable. De plus un tel actionneur permet de rapprocher et écarter les organes de préhension de manière relativement précise, par exemple pour définir une zone de réception de dimension prédéfinie.

Le dispositif peut être destiné à être fixé à l'extrémité d'un bras de robot manipulateur. A cet égard, La base peut être pourvue d'un organe de raccordement adapté pour raccorder la base à un robot manipulateur, comprenant notamment un bras articulé.

### BREVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 2 représente schématiquement un dispositif de préhension selon un mode de réalisation de l'invention, disposé au bout d'un robot manipulateur, et montre le dispositif de préhension en train de décharger, à l'aide du robot manipulateur, des plaquettes d'un des inserts de la figure 1b;
- la figure 3 est une vue en perspective, schématique et partielle, du dispositif de préhension pris de manière isolée ;
- la figure 4a est une vue en perspective, schématique et partielle, d'une portion d'extrémité proximale d'un des organes de préhension du dispositif de préhension;
- la figure 4b est une vue en perspective, schématique et partielle, d'un autre des organes de préhension du dispositif de préhension, pris de manière isolée ;
- la figure 4c est une vue en perspective, schématique et partielle, d'une portion d'extrémité distale de l'organe de préhension de la figure 4a; et
- la figure 5 est une vue en perspective, schématique et partielle, du dispositif de préhension selon une variante de réalisation.

### DESCRIPTION DETAILLEE DE L'INVENTION

Des parties identiques, similaires ou équivalentes des différentes figures portent les mêmes références numériques de façon à faciliter le passage d'une figure à l'autre.

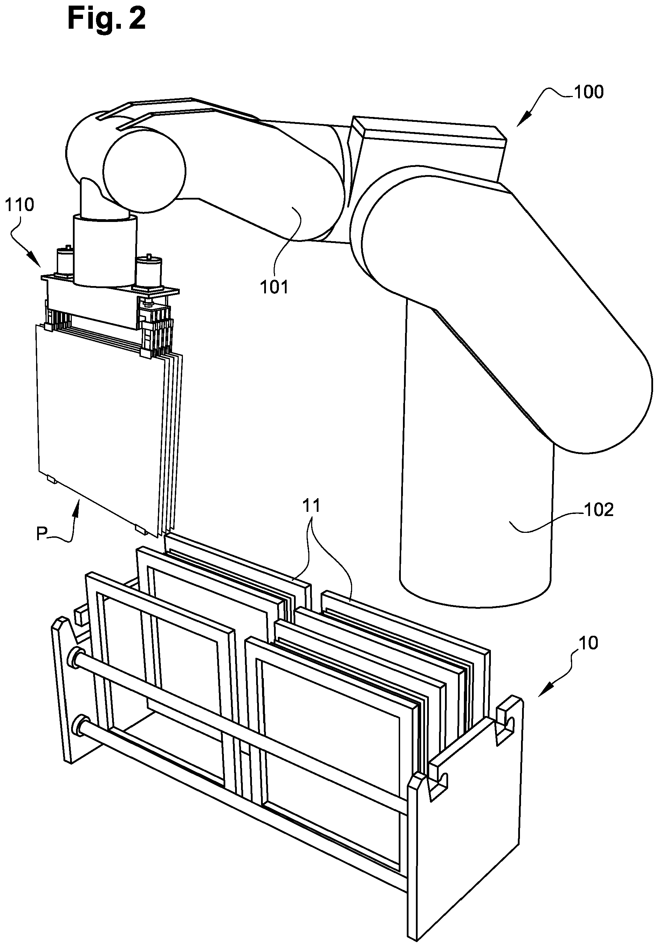

La figure 2 représente un dispositif de maintien 10, similaire à celui illustré à la figure 1b, et ensemble de manutention, comprenant un robot manipulateur 100 et un dispositif de préhension 110, qui décharge simultanément une pluralité de plaquettes P du dispositif de maintien 10. Le dispositif de préhension 110 est monté à l'extrémité d'un bras 101 du robot manipulateur 100. Le robot manipulateur 100 comporte un châssis 102 sur lequel le bras 101 est articulé. L'ensemble de manutention permet ainsi de décharger, de manière automatisée, plusieurs plaquettes P simultanément et selon différentes orientations du dispositif de maintien 10.

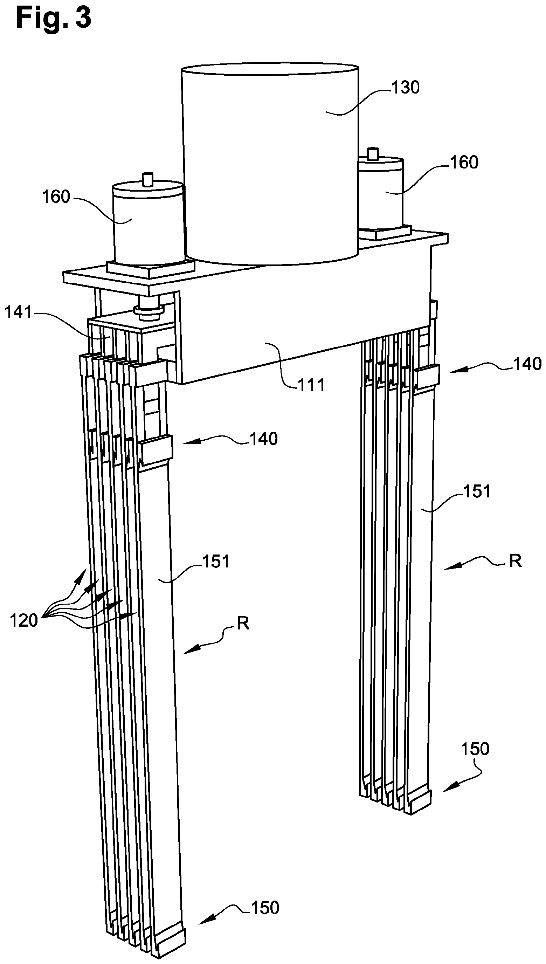

La figure 3 montre de manière isolée le dispositif de préhension 110 selon un premier mode de réalisation de l'invention. Ce dispositif 100 comprend une base 111 et plusieurs unités de préhension 120. Chaque unité de préhension 120 est configurée pour saisir une plaquette P par des bords opposés. Dans l'exemple illustré, le dispositif 110 comprend cinq unités de préhension 120 et est ainsi capable de saisir cinq plaquettes P simultanément.

Chaque unité de préhension 120 comprend au moins une paire d'organes de préhension, à savoir un organe de préhension supérieur 140 et un organe de préhension inférieur 150. Les organes de préhension 140 et 150 sont disposés en regard et à distance l'un de l'autre de sorte à définir une zone de réception R entre eux. La zone de réception R est destinée à recevoir une plaquette P et ses dimensions peuvent varier en fonction de la taille de la plaquette.

Les organes de préhension 140 et 150 définissent un plan de l'unité de préhension 120. Les unités de préhension 120 sont espacées les unes des autres selon une direction perpendiculaire à ce plan. La distance séparant deux unités de préhension 120 consécutives, selon cette direction, peut varier en fonction de l'épaisseur des plaquettes P à saisir et/ou de la distance séparant ces plaquettes. En effet, l'espace entre deux unités de préhension 120 consécutives doit permettre le passage, sans contact, d'une plaquette P en vue de sa préhension.

Chaque unité de préhension 120 a une épaisseur, selon la direction perpendiculaire au plan qu'elle définit, adaptée pour pouvoir l'introduire entre deux plaquettes P consécutives logées dans un dispositif de maintien, sans venir au contact de ces plaquettes. Ainsi, chaque unité de préhension a, par exemple, une épaisseur inférieure à 4,76 mm pour des plaquettes de taille M2 ou à 6,3 mm pour des plaquettes de taille M12. L'épaisseur des unités de préhension peut néanmoins varier selon la taille des plaquettes.

Chaque unité de préhension 120 comporte deux supports, à savoir un support supérieur 141 et un support inférieur 151. Le support supérieur 141 porte l'organe de préhension supérieur 140 et le support inférieur 151 porte l'organe de préhension inférieur 150. Les supports 141 et 151 ont ici une forme de lame allongée et s'inscrivent dans un même plan, ce qui permet de limiter l'épaisseur des unités de préhension 120. Les organes de préhension 140 et 150 saillent respectivement depuis une face principale du support supérieur 141 et du support inférieur 151 de sorte à être en regard l'un de l'autre.

Le dispositif de préhension 110 comprend, en outre, un moyen de déplacement 160 configuré pour rapprocher et écarter les organes de préhension 140, 150 l'un de l'autre et ainsi faire varier un espace de la zone de réception R entre une configuration d'insertion et une configuration de verrouillage de la plaquette P dans laquelle les organes de préhension 140, 150 sont rapprochés par rapport à ladite configuration d'insertion. L'actionnement du moyen de déplacement 160 permet de passer de l'une à l'autre des configurations de verrouillage et d'insertion.

Dans l'exemple illustré, le moyen de déplacement 160 est rattaché à l'organe de préhension supérieur 140, qui est mobile par rapport à la base 111, tandis que l'organe de préhension inférieur 150 est fixe par rapport à la base 111. L'actionnement du moyen de déplacement 160 permet ainsi de faire varier la distance entre les organes de préhension 140, 150 en agissant uniquement sur l'organe de préhension supérieur 140, ce qui simplifie la conception du dispositif. Le moyen de déplacement 160 comprend avantageusement un axe numérique, afin de déplacer l'organe de préhension supérieur de manière relativement précise, et ainsi ajuster précisément la distance entre les organes de préhension 140, 150.

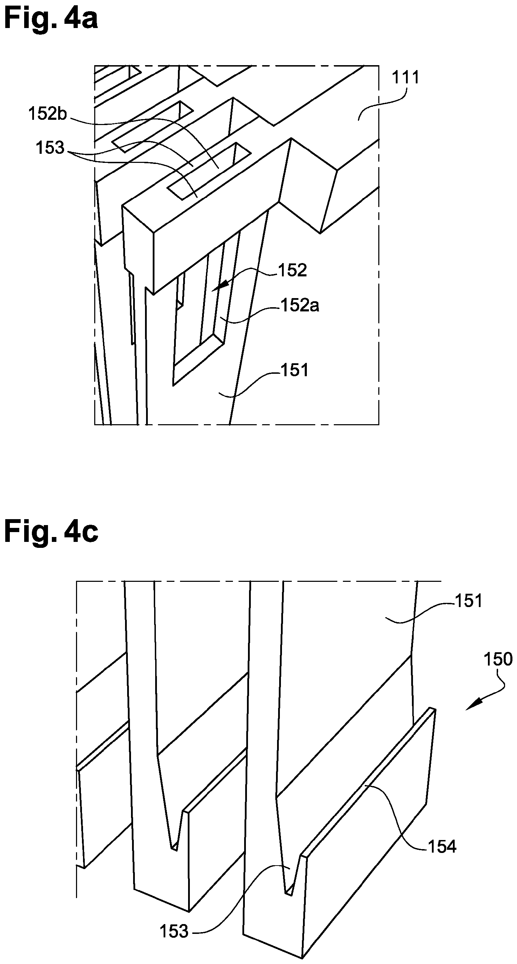

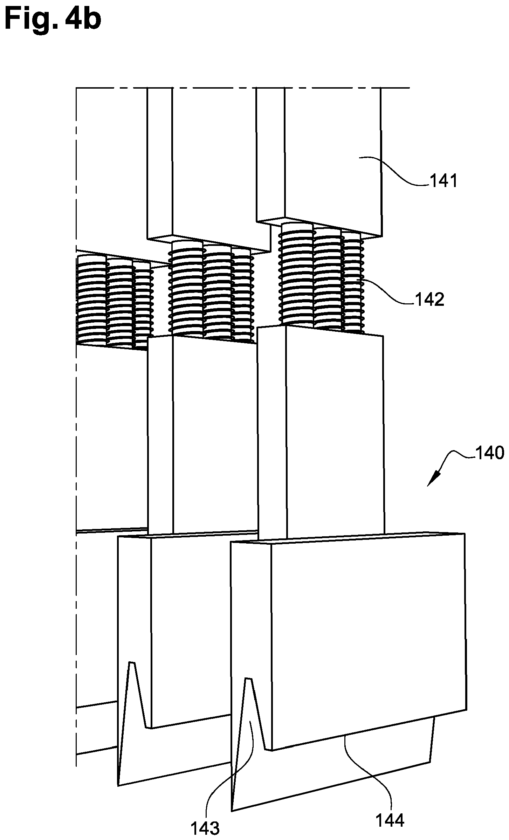

Il est maintenant décrit, en référence aux figures 4a et 4b, un mécanisme permettant à l'organe de préhension supérieur 140 se déplacer par rapport à l'organe de préhension inférieur 150 selon un mouvement coulissant. La figure 4a illustre l'organe de préhension supérieur 140 avec le support supérieur 141 pris de manière isolée et la figure 4b illustre une portion d'extrémité proximale du support inférieur 141, également pris de manière isolée.

Comme le montre la figure 4a, le support inférieur 151 est pourvu, à son extrémité proximale, d'une fente 152 adaptée recevoir et à guider le support supérieur 141 selon une direction rectiligne orientée vers l'organe de préhension inférieur 150. Ainsi, le support inférieur 151 sert à la fois de support pour l'organe de préhension inférieur 150 et de moyen de guidage pour l'organe de préhension supérieur 140.

La fente 152 présente une première portion 152a le long de laquelle la fente est ouverte sur la face du support inférieur 151 dont saille l'organe de préhension inférieur 150, et une deuxième portion 152b le long de laquelle la fente est délimitée par des parois, ici au nombre de quatre.

Dans l'exemple représenté, la première portion 152a de la fente 152 est traversante. La deuxième portion 152b est délimitée par deux éléments de blocage 153 disposés de part et d'autre du support inférieur 151. L'un de ces éléments de blocage 153 est de préférence démontable pour ouvrir totalement la fente 152 sur l'une des faces du support inférieur 151 et ainsi faciliter l'insertion de l'organe de préhension supérieur 140 et/ou de son support 141 dans la fente 152.

En référence maintenant à la figure 4b, une portion du support supérieur 141 est conformée de sorte à coopérer avec la fente 152 selon une liaison glissière. En particulier, le support supérieur 141 présente une portion de forme complémentaire à celle de la fente 152. L'organe de préhension supérieur 140 fait saillie depuis une face du support supérieur 141 afin d'être en regard avec l'organe de préhension inférieur 150 lorsque le support supérieur 141 est reçu dans la fente 152.

En pratique, une portion du support supérieur 141 est insérée dans la fente 142, par exemple en retirant l'un des éléments de blocage 153, jusqu'à venir en appui contre l'autre des éléments de blocage 153. Lorsque la portion du support supérieur 141 est insérée dans la fente 152, l'organe de préhension supérieur 140 traverse la première portion 152a de la fente 152 de sorte à être regard de l'organe de préhension inférieur 150. La deuxième portion 152b maintient le support supérieur 141 à l'intérieur de la fente 152, notamment au cours de son déplacement sous l'action du moyen de déplacement 160. De fait, le dispositif de préhension 110 passe d'une configuration à une autre sans que son épaisseur (ou l'épaisseur d'une unité de préhension 120) ne varie, ce qui est avantageux pour décharger des plaquettes logées dans un dispositif de maintien.

De façon optionnelle, l'organe de préhension supérieur 140 est rattaché au support supérieur 141 par un moyen d'amortissement 142. Le moyen d'amortissement 142 est adapté pour se déformer, de préférence élastiquement, lorsqu'une contrainte s'exerçant sur l'organe de préhension supérieur 140 est supérieure à une contrainte prédéfinie. Le moyen d'amortissement 142 permet notamment d'absorber, au moins partiellement, un effort s'exerçant sur la plaquette P par le biais de l'organe de préhension supérieur 140 lorsqu'il est déplacé par le moyen de déplacement 160. Dans l'exemple illustré, le moyen d'amortissement 142 comprend un ressort de compression hélicoïdal dont les extrémités sont reliées respectivement au organe de préhension supérieur 140 et au support supérieur 141.

L'organe de préhension supérieur 140 comprend une encoche 143 adaptée pour recevoir au moins une portion d'un bord, notamment supérieur, d'une plaquette P. L'encoche 143 définit un rebord 144, s'étendant sensiblement parallèlement au support supérieur 141 et empêchant le mouvement de la plaquette P selon une direction perpendiculaire à un plan général de la plaquette P. L'encoche 143 possède ici un profil en forme de V, ce qui permet de maintenir la plaquette P à distance du support supérieur 141 tout en limitant la surface de contact entre les faces de la plaquette P et les parois de l'encoche 143.

Comme le montre la figure 4c, l'organe de préhension inférieur 150 est similaire au organe de préhension supérieur 140 et comprend, de fait, une encoche 153 adaptée pour recevoir au moins une portion d'un bord, notamment inférieur, de la plaquette P et définissant un rebord 154. L'encoche 154 possède aussi un profil en forme de V. L'organe de préhension inférieur 150 est tourné vers l'organe de préhension supérieur 140, pour que les encoches 143, 153 soient en regard l'une de l'autre.

Les encoches 143, 153 définissent un plan qui correspond au plan de l'unité de préhension 120 correspondante. Les supports supérieur et inférieur 141, 151 s'étendent parallèlement au plan défini par les encoches 143, 153. Chaque encoche 143, 153 est agencée de telle sorte qu'il un axe perpendiculaire à ce plan (le plan défini par les encoches 143, 153) qui passe à la fois par l'encoche et par le support portant l'organe de préhension définissant ladite encoche. Cet agencement, combiné au déplacement coulissant des organes de préhension (suivant un axe parallèle au plan défini par les encoches) facilite la saisie d'une ou de plusieurs plaquettes directement depuis un panier, tel que ceux illustrés aux figures 1a et 1b. Elle permet de disposer et de rapprocher ou écarter les organes de préhension entre deux plaquettes, sans endommager ces dernières.

Dans l'exemple illustré, chaque unité de préhension comporte deux paires d'organe de préhension 140, 150 espacées l'une de l'autre et agencées de telle manière que les quatre organes de préhension 140, 150 définissent un rectangle, voire un carré.

Cet agencement améliore la stabilité de la plaquette P dans la zone de réception, notamment par rapport à une unité de préhension à une seule paire d'organe de préhension. D'autres agencements à quatre organes de préhension peuvent être envisagées, notamment une configuration trapézoïdale.

Pour déplacer simultanément les deux organes de préhension supérieur 140, les supports supérieurs 141 sont rattachés l'un à l'autre, de préférence au niveau de leur extrémité proximale, par un élément de liaison. Le moyen de déplacement 160 est assujetti à l'élément de liaison et agit ainsi de manière simultanée sur chaque organe de préhension supérieur 140. Grâce à l'élément de liaison, le moyen de déplacement pourrait bien entendu ne comprendre qu'un seul un seul axe numérique. Il est également possible de ne pas prévoir d'élément de liaison, auquel cas les axes numériques sont assujettis à chacun des supports supérieurs et configurés pour les déplacer simultanément.

La base 111 est pourvue d'un organe de raccordement 130 configuré pour permettre le raccordement de la base 111 au bras 101 du robot manipulateur 100.

L'organe de raccordement 130 peut également permettre de coupler électriquement le moyen de déplacement 160 à un module de contrôle (non représenté) intégré dans le robot manipulateur 100 et configuré pour actionner le moyen de déplacement. Un tel module de contrôle peut bien entendu être distant.

Pour la préhension d'une ou de plusieurs plaquettes, notamment en vue de leur extraction du dispositif d'immersion, par le biais du dispositif de préhension, le procédé comporte les étapes ci-dessous.

Le dispositif de préhension 110 est connecté, par le biais de l'organe de raccordement 130, à l'extrémité du bras 101 du robot manipulateur 100. Si le dispositif 110 se trouve dans sa configuration d'insertion, il est laissé dans cette configuration. Dans la négative, le dispositif 110 est passé de sa configuration de verrouillage vers sa configuration d'insertion par l'actionnement du moyen de déplacement 160 pour écarter les organes de préhension 140, 150, par exemple au moyen du module de contrôle.

Le dispositif 110 est ensuite déplacé, par le biais du robot manipulateur 100, parallèlement à un plan principal de la ou des plaquettes P, jusqu'à ce que l'organe de préhension inférieur 150 franchisse le bord inférieur de la ou des plaquettes P, tandis que l'organe de préhension supérieur 140 ne franchit pas le bord supérieur, afin de pouvoir recevoir la ou les plaquettes P dans les zones de réception R correspondantes. Le dispositif 110 est alors déplacé perpendiculairement au plan principal de la ou des plaquettes P, en direction de ces dernières, jusqu'à ce que la ou les plaquettes P se trouvent dans leur zone de réception R respective entre les organes de préhension 140, 150 et en regard de leur encoche 143, 153 respective.

L'organe de préhension supérieur 140 et l'organe de préhension inférieur 150 sont alors rapprochés des bords de la ou des plaquettes P. En particulier, l'organe de préhension inférieur 150 est d'abord rapproché du bord inférieur de la ou les plaquettes P en déplaçant le dispositif de préhension 110 (vers le haut sur la figure 2) parallèlement au plan principal des plaquettes P, puis l'organe de préhension supérieur 140 est rapproché du bord supérieur des plaquettes P en actionnant le moyen de déplacement 160 pour passer le dispositif 110 de sa configuration d'insertion à sa configuration d'enserrement. Il convient de noter que, lorsque l'organe de préhension supérieur est déplacé pour se rapprocher du bord supérieur, le dispositif de préhension 100 (et donc l'organe de préhension inférieur) n'est pas déplacé. La ou les plaquettes P sont ainsi verrouillées par les organes de préhension 140, 150 dans les zones de réception R respective.

Dans l'exemple illustré, ni le robot manipulateur 100, ni le dispositif de préhension 110, n'est équipé de capteurs pour déterminer la position du dispositif de préhension par rapport à la ou les plaquette P. En pratique, le robot manipulateur 100 est configuré pour positionner le dispositif de préhension à des emplacements prédéfinis, auxquels la ou les plaquettes P sont disposées. Toutefois, le robot manipulateur et/ou le dispositif de préhension peut être équipé de capteurs pour détecter la présence et/ou le contact avec la ou les plaquettes. Par exemple, le robot manipulateur être couplé à un système de vision.

Lorsque la ou les plaquettes P sont verrouillées, les organes de préhension 140 et 150, et plus particulièrement l'organe de préhension supérieur, ne sont pas nécessairement au contact des bords de la ou des plaquettes P. Cela est permis grâce au rebord de chaque organe de préhension 140 et 150, qui permet de maintenir la plaquette P dans l'espace de réception sans appliquer le moindre effort de serrage sur la plaquette. Il est ainsi préférable, notamment pour éviter d'endommager les plaquettes P, de rapprocher l'organe de préhension supérieur 140 sans venir au contact du bord supérieur, mais jusqu'à une distance telle que le bord supérieur est au moins partiellement reçu dans l'encoche 143. Il convient également de noter que dans l'exemple représenté, le bord inférieur des plaquettes P vient nécessairement au contact, par gravité, avec le fond de l'encoche 153 des organes de préhension inférieurs 150.

Le dispositif de préhension 110 permet, grâce à la configuration de son système à organe de préhension 140 et 150, de saisir une plaquette P de matériau semi-conducteur, qui est par exemple insérée dans un dispositif d'immersion 1 ou 10, par des bords opposés. Le dispositif 110 permet aussi de sélectionner les plaquettes P à saisir, par exemple pour leur déchargement du dispositif d'immersion 1 ou 10, contrairement à la courroie avec laquelle les plaquettes P doivent être déchargées consécutivement selon leur ordre d'empilement. Il est également possible, avec un dispositif 110 comportant plusieurs unités de préhension 120, de saisir plusieurs plaquettes P simultanément.

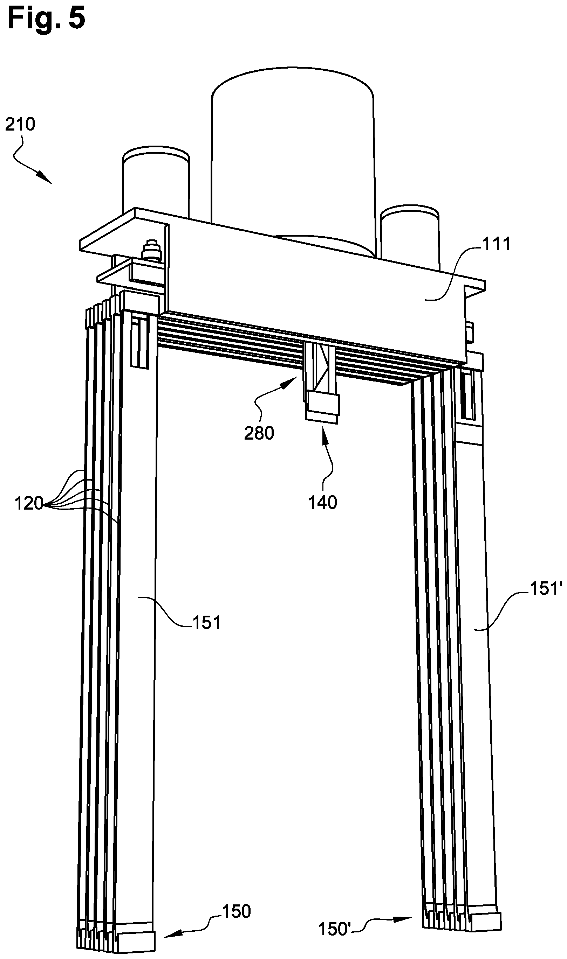

La figure 5 montre une variante de réalisation du dispositif de préhension 210, dans lequel seul le nombre et l'agencement de l'organe de préhension supérieur diffère du premier mode de réalisation.

Dans ce dispositif de préhension 210, chaque unité de préhension 120 comprend une paire d'organes de préhension 140 et 150 et un troisième organe de préhension 150', ici aligné avec l'organe de préhension inférieur 150 selon une direction perpendiculaire à la direction de rapprochement/d'écartement des organes de préhension. Les organes de préhension 140, 150, 150' sont disposés selon une configuration triangulaire, l'organe de préhension supérieur 140 se situant entre les organes de préhension inférieurs 150 et 150'. La stabilité de la plaquette avec un tel agencement est légèrement plus faible qu'avec un agencement à quatre organes de préhension, mais plus grande qu'avec un dispositif à deux organes de préhension.

Le dispositif 210 comprend un support de guidage 280 de l'organe de préhension supérieur 150, assujetti à la base 111 et disposé entre les supports inférieurs 151, 151'. Le support de guidage 280 comprend par exemple une fente, similaire à celle décrite dans le premier mode de réalisation.

Des variantes non illustrées sont décrites ci-dessous.

Le moyen de déplacement peut comprendre d'autres types d'actionneurs, tels que des vérins hydrauliques ou pneumatiques. Le moyen de déplacement peut également comprendre plus ou moins d'actionneurs.

Le dispositif de préhension peut comprendre plus ou moins d'unités de préhension, par exemple entre une et quatre ou plus de cinq.

Le moyen d'amortissement peut comprendre plus ou moins de ressorts.

L'encoche peut présenter d'autres formes de profil, par exemple rectangulaire ou arrondie.

## Revendications

1. Dispositif de préhension d'au moins une plaquette (P) de matériau semi-conducteur, comprenant au moins une unité de préhension (120) comprenant une paire d'organes de préhension (140, 150, 150') disposés à distance l'un de l'autre et comportant chacun une encoche (143, 153), l'encoche (143, 153) d'un des organes de préhension (140, 150, 150') étant adaptée pour recevoir un bord de ladite au moins une plaquette (P) tandis que l'encoche (153, 143) de l'autre des organes de préhension (150, 140, 150') étant adaptée pour recevoir un bord opposé de ladite au moins une plaquette (P), et un moyen de déplacement (160) configuré pour rapprocher/écarter les organes de préhension (140, 150, 150') l'un de l'autre entre une configuration de verrouillage de l'au moins une plaquette (P) en vue de sa préhension et une configuration d'insertion, **caractérisé en ce qu'**il comprend plusieurs unités de préhension (120) espacées les unes des autres selon une direction perpendiculaire à un plan défini par les organes de préhension (140, 150, 150') d'une des unités de préhension.

2. Dispositif selon la revendication 1, **caractérisé en ce que** chaque encoche (143 ; 153) possède un profil en forme de V.

3. Dispositif selon la revendication 1 ou 2, **caractérisé en ce que** les organes de préhension (140, 150, 150') sont configurés pour coulisser l'un par rapport à l'autre selon une direction de rapprochement/d'écartement des organes de préhension (140, 150, 150') sous l'action du moyen de déplacement (160).

4. Dispositif selon l'une quelconque des revendications 1 à 3, **caractérisé en ce que** ladite au moins une unité de préhension (120) comporte un troisième organe de préhension (150'), les organes de préhension (140, 150, 150') étant disposés selon une configuration triangulaire, les encoches (143, 153) de deux de ces organes de préhension (140, 150) étant adaptées pour recevoir un même bord de l'au moins une plaquette (P), ou l'au moins une unité de préhension (120) comporte une autre paire d'organes de préhension (140, 150), les organes de préhension (140, 150) étant disposés selon une configuration globalement rectangulaire, chaque paire comportant un organe de préhension (140, 150) dont l'encoche (143, 153) est adaptée pour recevoir un bord de l'au moins une plaquette (P) et un organe de préhension (150, 140) dont l'encoche (153, 143) est adaptée pour recevoir un bord opposé de ladite au moins une plaquette (P).

5. Dispositif selon l'une quelconque des revendications 1 à 4, **caractérisé en ce qu'**au moins l'un des organes de préhension (140, 150, 150') est associé à un moyen d'amortissement (142) configuré pour se déformer élastiquement au-delà d'une contrainte prédéterminée s'exerçant lorsque les organes de préhension (140, 150, 150') se rapprochent l'un de l'autre.

6. Dispositif selon la revendication 5, caractérisé en ce le moyen d'amortissement (142) comporte un ressort de compression.

7. Dispositif selon l'une quelconque des revendications 1 à 6, **caractérisé en ce que** le moyen de déplacement (160) comprend un axe numérique.

8. Procédé de préhension d'au moins une plaquette (P) de matériau semi-conducteur, à l'aide d'un dispositif de préhension (110, 210) selon l'une quelconque des revendications 1 à 7, **caractérisé en ce qu'**il comprend les étapes suivantes :
- déplacer ledit dispositif de préhension (110, 210), dans sa configuration d'insertion, jusqu'à ce que l'au moins une plaquette (P) se trouve entre la paire d'organes de préhension (140, 150, 150') de l'au moins une unité de préhension (120),
- actionner le moyen de déplacement (160) pour faire passer le dispositif de préhension (110, 210) de sa configuration d'insertion à sa configuration de verrouillage pour la préhension de ladite au moins une plaquette (P).

9. Ensemble de préhension comportant un dispositif de maintien (1, 10), au moins une plaquette (P) insérée dans le dispositif de maintien (1, 10), un robot manipulateur (100), et un dispositif de préhension (110, 210) selon l'une quelconque des revendications 1 à 7 qui est monté sur le robot manipulateur (100), ledit robot manipulateur (100) étant configuré pour déplacer le dispositif de préhension (110, 210), dans sa configuration d'insertion, jusqu'à ce que l'au moins une plaquette (P) se trouve entre la paire d'organes de préhension (140, 150, 150') de l'au moins une unité de préhension (120) et le moyen de déplacement (160) étant configuré pour faire passer le dispositif de préhension (110, 210) de sa configuration d'insertion à sa configuration de verrouillage pour la préhension de ladite au moins une plaquette (P).
